(19) Europäisches Patentamt

European Patent Office

Office européen des brevets

(11) Veröffentlichungsnummer: **0 410 022 A1**

(12) **EUROPÄISCHE PATENTANMELDUNG**

(21) Anmeldenummer: **89113578.2**

(22) Anmeldetag: **24.07.89**

(51) Int. Cl.⁵: **H03D 13/00, G01R 25/00**

(43) Veröffentlichungstag der Anmeldung:
**30.01.91 Patentblatt 91/05**

(84) Benannte Vertragsstaaten:
**AT BE CH ES FR GB IT LI NL SE**

(71) Anmelder: **ALCATEL N.V.**
**Strawinskylaan 341 (World Trade Center)**
**NL-1077 XX Amsterdam(NL)**

(72) Erfinder: **Heide, Josef**
**Schubertstrasse 8**
**D-7062 Rudersberg(DE)**
Erfinder: **Berger, Werner**
**Lachpfädle 38**
**D-7257 Ditzingen(DE)**

(74) Vertreter: **Gähr, Hans-Dieter, Dipl.-Ing. (FH) et al**
**Standard Elektrik Lorenz AG Patent- und Lizenzwesen Postfach 30 09 29**
**D-7000 Stuttgart 30(DE)**

(54) **Phasen- und frequenzempfindlicher Detektor.**

(57) Bekannt ist ein phasen- und frequenzempfindlicher Detektor für digitale Taktimpulse, der Eingangstaktimpulse mit Bezugstaktimpulsen vergleicht und wegen des Verhältnisses der Verzögerungszeit, wie sie in den einzelnen Bauelementen des Detektors auftritt, oder der Impulsdauer zur Periodendauer keine Ausnutzung der höchsten, in den einzelnen Bauelementen noch zulässigen Taktimpulsfolgefrequenz gestattet.

Der erfindungsgemäße Detektor ist hinsichtlich der maximal verarbeitbaren Taktimpulsfolgefrequenz verbessert.

Wie der bekannte Detektor hat der neue zwei Frequenzteilerschaltungen (1, 2) mit zyklischen Zählern (5, 6) und eine bistabile Kippschaltung (9) am Ausgang, deren Ausgangssignal ein Maß für die vorliegende Frequenz- und Phasenabweichung zwischen Eingangs- und Bezugstaktimpulsen ist. Erfindungsgemäß enthält er zwei Logikschaltungen (7, 8), die Signale aus den zugehörigen zyklischen Zählern (5, 6) und aus den Ausgängen (Q, Q) der bistabilen Kippschaltung (9) erhalten.

Die Logikschaltung (7, 8) verhindert das Weiterzählen des Zählers (5, 6) solange, bis auf einen digitalen Zustand am Ausgang (Q, $\overline{Q}$) der bistabilen Kippschaltung (9) der zu diesem Zustand komplementäre gefolgt ist.

FIG.1

## PHASEN- UND FREQUENZEMPFINDLICHER DETEKTOR

Die Erfindung betrifft einen phasen- und frequenzempfindlichen Detektor für digitale Taktimpulse nach dem Oberbegriff des Anspruchs 1.

Solche Detektoren finden sich insbesondere in Phasenregelschleifen; sie können auch als Phasendemodulatoren dienen.

In Phasenregelschleifen vergleichen Phasendetektoren ein Eingangssignal mit einem von einem spannungsgesteuerten Oszillator erzeugten Bezugssignal bezüglich ihrer Phasenlage. Ein digital arbeitender Phasendetektor erzeugt impulsförmige Ausgangssignale, aus denen in einem ihm nachgeschalteten Schleifenfilter, das als Tiefpaß ausgebildet ist, der eigentliche Phasenfehler abgeleitet und dem spannungsgesteuerten Oszillator zugeführt wird.

Es sind Phasendetektoren bekannt, die nicht nur phasen-, sondern auch noch frequenzempfindlich sind und ein dem Frequenzfehler entsprechendes Ausgangssignal liefern, solange Eingangs- und Bezugssignal unterschiedliche Frequenzen aufweisen.

Ein solcher phasen- und frequenzempflindlicher Detektor nach dem Oberbegriff des Anspruchs 1 ist bekannt aus der US-PS 3 723 889. Er enthält für beide Signale jeweils eine Frequenzteilerschaltung mit je einem zyklischen Zähler.

Über eine UND-Schaltung werden die Überlaufimpulse mit den Taktimpulsen, die nicht durch den Zähler gelaufen sind, einem RS-Flip-Flop zugeführt. Weil der Zähler eine Verzögerung $t_{pd}$ verursacht, die sich in der nachfolgenden UND-Schaltung fortpflanzt, ist es für das Funktionieren der Schaltung erforderlich, daß in der UND-Schaltung der von einem n-ten Taktimpuls herrührende positive Ausgangszustand des Zählers mit dem $(n+1)$-ten Taktimpuls zusammenkommt; dies bedeutet, daß die Taktimpulsdauer $t_p$ stets kürzer sein muß als die Verzögerung $t_{pd}$.

Diese Bedingung ist erfüllbar, wenn die Taktimpulse mit Hilfe von Flankendetektoren oder Laufzeitelementen an den Ausgängen der Zähler zu Nadelimpulsen verschmälert werden. Dadurch werden aber die Pausen größer. Die Zähler müssen einerseits zwar die Maximalfrequenz

$$f_{max} = \frac{1}{t_p}$$

verarbeiten können, andererseits wird jedoch die maximale Taktimpulsfolgefrequenz durch den Abstand der Nadelimpulse bestimmt und liegt wesentlich niedriger. Die kurze Dauer der Nadelimpulse erfordert Schaltungen für hohe Frequenzen, deren Leistungsfähigkeit wegen der erforderlichen langen Pausen nicht ausgenutzt werden kann. Dies ist insbesondere bei Schaltungen in ECL-Technologie störend, da es bei vorgegebener Taktimpulsfolgefrequenz auf die volle Ausnutzung der in diesen Bausteinen noch zulässigen Frequenz ankommt.

Der Erfindung liegt die Aufgabe zugrunde, einen phasen-und frequenzempfindlichen Detektor anzugeben, der sich bei der Grenzfrequenz der verwendeten Bausteine betreiben läßt und keine Anforderungen an die Form der Taktimpulse stellt.

Die Aufgabe wird gelöst, wie in Patentanspruch 1 angegeben. Weiterbildungen ergeben sich aus den Unteransprüchen.

Die Erfindung wird anhand der Figuren beispielsweise erläutert. Es zeigen

Fig. 1 einen erfindungsgemäßen phasen- und frequenzempfindlichen Detektor,

Fig. 2 den Aufbau der in Fig. 1 gezeigten Logikschaltung 7,

Fig. 3 ein Taktimpuls- und Zustandsdiagramm.

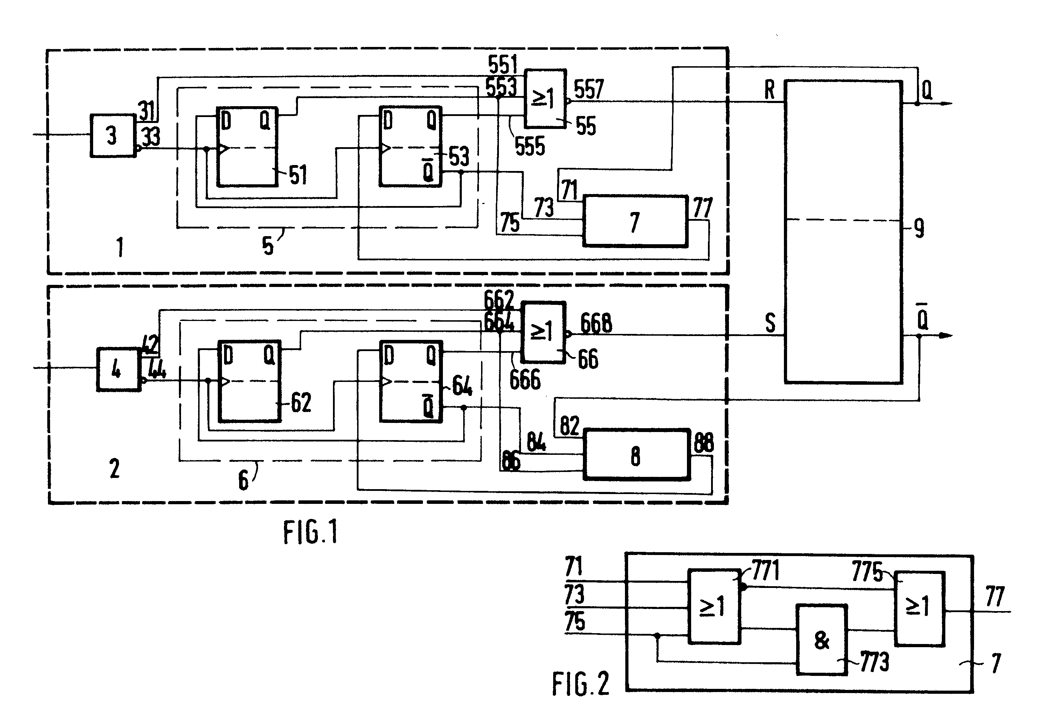

Der in Fig. 1 gezeigte Detektor vergleicht digitale Eingangstaktimpulse mit digitalen Bezugstaktimpulsen. Die Eingangs- und Bezugstaktimpulse durchlaufen eine erste, 1, bzw. eine zweite Frequenzteilerschaltung 2, bis sie zu einer bistabilen Kippschaltung 9 gelangen, die in diesem Falle ein RS-Flip-Flop ist.

Die Frequenzteilerschaltungen 1, 2 sind gleich aufgebaut.

Die Beschreibung beschränkt sich daher auf die Frequenzteilerschaltung 1, deren Bauelemente in der Figur mit ungeraden Zahlen bezeichnet sind. Die Bauelemente der Frequenzteilerschaltung 2 sind mit geraden Zahlen bezeichnet, deren Ziffern jeweils um 1 erhöht sind.

Die Eingangstaktimpulse werden einem Takttreiber 3 zugeführt, der im Ausführungsbeispiel einen invertierenden Ausgang 31 und einen nichtinvertierenden Ausgang 33 hat.

Der Ausgang 31 ist mit einem Eingang 551 einer NOR-Schaltung 55 mit drei Eingängen 551, 553, 555 und einem Ausgang 557 verbunden.

Der Ausgang 33 ist mit Takt-Eingängen zweier D-Flip-Flops 51, 53 verbunden, die mit fallender Taktflanke schalten und einen zyklischen Zähler 5 bilden.

Da der Q-Ausgang der D-Flip-Flops 51 nicht unmittelbar, sondern über einen Eingang 75 und einen Ausgang 77 einer Logikschaltung 7 mit dem D-Eingang der D-Flip-Flops 53 verbunden ist, ist der zyklische Zähler 5 kein normaler, sondern ein modifizierter Johnson-Zähler.

Der $\overline{Q}$ -Ausgang des Flip-Flops 53 ist mit dem D-Eingang des Flip-Flops 51 verbunden.

Die Q-Ausgänge beider D-Flip-Flops 51, 53 sind mit dem Eingang 553 bzw. 555 der NOR-Schaltung 55 verbunden. Aus deren Ausgang 557 werden Signale zum R-Eingang eines RS-Flip-Flops 9 geführt, dessen Q-Ausgang mit einem Eingang 71 der Logikschaltung 7 verbunden ist.

Ein Eingang 73 der Logikschaltung 7 ist mit dem $\overline{Q}$ -Ausgang des D-Flip-Flops 53 verbunden.

Anhand von Fig. 2 wird die Logikschaltung 7 nun näher erläutert. Die Figur zeigt zwei ODER-Schaltungen 771, 775 und eine UND-Schaltung 773. Die ODER-Schaltung 771 ist mit den Eingängen 71, 73 und 75 verbunden.

Ein nicht-invertierender Ausgang der ODER-Schaltung 771 und der Eingang 75 bilden die Eingänge der UND-Schaltung 773.

Ein invertierender Ausgang der ODER-Schaltung 771 und der Ausgang der UND-Schaltung 773 sind mit den beiden Eingängen der ODER-Schaltung 775 verbunden, deren Ausgang den Ausgang 77 der Logikschaltung 7 bildet. Eine Logikschaltung 8 in Fig. 1 ist in gleicher Weise aufgebaut, mit dem Unterschied, daß ihr Ausgang 88 mit dem $\overline{Q}$ - Ausgang der RS-Flip-Flops 9 verbunden ist.

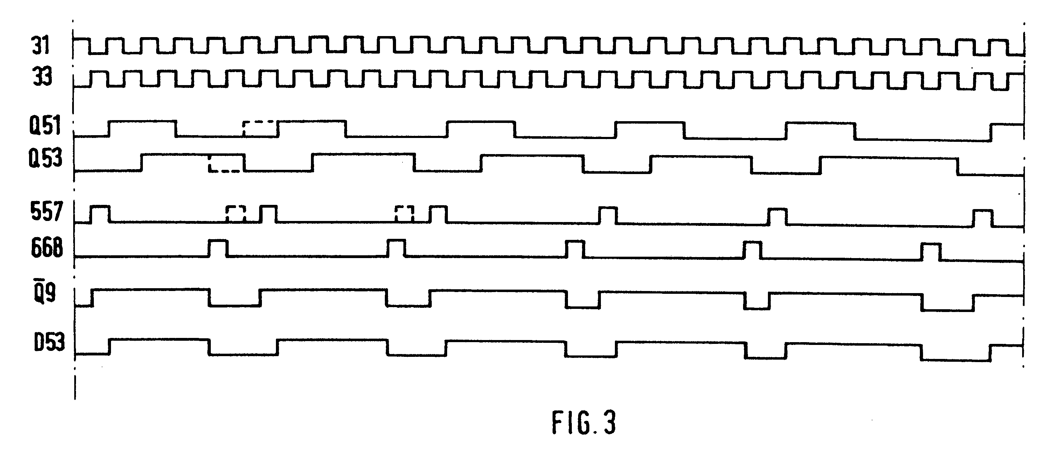

Anhand von Fig. 3 wird die Arbeitsweise der Schaltung erläutert. In ihr sind zur Vereinfachung die Taktimpulse und Zustände in Anlehnung an die Bezeichnungsweise für Ein- oder Ausgänge, an denen sie auftreten, benannt. Dargestellt sind die nicht-invertierten Taktimpulse 31, und invertierten Taktimpulse 33, die Zustände Q51, Q53 an den Q-Ausgängen der D-Flip-Flops 51, 53, die Zustände 557, 668 an den Ausgängen 557, 668 der Logikschaltungen 7, 8 am Q-Ausgang, Q9, des RS-Flip-Flops 9 und am D-Eingang, D53, des D-Flip-Flops 53.

Sofern an mindestens einem der drei Eingänge 71, 73, 75 der ODER-Schaltung 771 aus Fig. 2 der Zustand 1 anliegt, zählt der Zähler im Johnson-Modus zyklisch N Zustände. Bei 2 D-Flip-Flops lassen sich wegen der Unterscheidung von 2 Zuständen je D-Flip-Flop N = 4 Zählerstände, 00, 01, 11, 01, zählen. Die Zahlfolge, d.h. die Zustände an den Q-Ausgängen der D-Flip-Flops 51, 53, bleibt in jedem Fall bei den Zählerständen 00, 10, 11 erhalten. Ob der Zähler 5 bei Zählerstand 01 mit der Periode der Eingangstaktimpulse 31 weiterzählt, hängt vom Zustand am Ausgang Q des RS-Flip-Flops 9 ab. Hat er sich seit der letzten Ansteuerung, (d.h. Setzen auf 1) durch das Signal 557 nicht mehr geändert und ist er nicht durch das Signal 668 auf 0 zurückgesetzt worden, so liegt an den Eingängen 71, 73 und 75 der Logikschaltung 7 jeweils der Zustand 0 an, und vom invertierenden Ausgang der ODER-Schaltung 771 wird Zustand 1 auf den D-Eingang des D-Flip-Flops 53 geschaltet.

Nach der nächsten aktiven Taktflanke befindet sich der Zähler 5 daher erneut im Zustand 01; er hat also nicht nach 00 weitergezählt. Der Übergang nach 00, und damit die Rückkehr zur durch die Periode der Eingangstaktimpulse gegebenen Zählweise, erfolgt erst, wenn das RS-Flip-Flop 9 durch Ansteuerung über das Signal 668 zurückgeschaltet wurde. Die zurückschaltenden Signale 668 können fehlen, wenn entweder die Eingangstaktimpulse unterbrochen werden, oder wenn sie eine niedrigere Frequenz haben als die Bezugstaktimpulse.

Als Folge des Eingriffs in die Zählfolge behält das RS-Flip-Flop 9 den Zustand bei, in den es zuletzt vom Signal 557 oder 668 gesetzt wurde, bis eine Ansteuerung mit dem jeweils anderen Signal erfolgt.

Die Frequenzempfindlichkeit ergibt sich daraus, daß der in seiner Zählfolge angehaltene Zähler nur eine halbe Periode der Taktimpulse 31, 33 vor einem erneuten Überlaufimpuls 557 bzw. 668 stehen bleibt. Wird das RS-Flip-Flop 9 endlich mit dem ausgebliebenen anderen Signal angesteuert, so wird schon mit der nächsten aktiven Taktflanke am Zähler 5 das RS-Flip-Flop 9 erneut in den ersten Zustand gesetzt, wodurch dieser gegenüber dem anderen dominiert. In der Figur ist die Änderung der Zählweise des Zählers 5 gegenüber der normalen (gestrichelte Linien) angedeutet.

Ohne die Zusatzbeschaltung der Zähler 5, 6 mit den Logikschaltungen 7, 8 würden bis zum nächsten Setzen des RS-Flip-Flops 9 in den Zustand 00 bis zu drei aktive Taktflanken benötigt, weil der Zähler weitergezählt hätte und gerade einen beliebigen der vier Zustände angenommen hätte.

Die Zusatzbeschaltung führt also bei Frequenz- oder Phasendifferenzen zwischen den Eingangs- und Bezugstaktimpulsen zur Bevorzugung eines Zustandes der RS-Flip-Flops 9. Nach Integration des Ausgangssignals, entweder Q oder $\overline{Q}$ , - dies entspricht einer Aussiebung des Hochfrequenzanteils - liefert das Ausgangssignal des RS-Flip-Flops 9 eine Gleichspannung, die der Richtung der Frequenzabweichung entspricht.

Wenn eine solche Phasenregelschleife bei Frequenzumsetzungen verwendet werden soll, müssen die Zähler entsprechend dem Frequenzverhältnis $f_1 : f_2 = N_1 : N_2$ die zugehörigen Teilerfaktoren $N_1$, $N_2$ haben.

Werden für die Zähler 5 und 6 D-Flip-Flops verwendet, die mit der ansteigenden Flanke der Taktimpulse schalten, müssen die Taktimpulse 31, 33 bzw. 42, 44 gleichphasig sein, so daß die Takttreiber 3 bzw. 4 entfallen.

Die NOR-Schaltungen 55 bzw. 66 können auch ohne die Eingänge 551 bzw. 662 ausgeführt werden; die Signale 557 bzw. 668 sind dann doppelt so lang; und der Phasenaussteuerbereich wird etwas kleiner, was durch hohe Teilerfaktoren N der Zähler 5, 6 ausgeglichen werden kann.

In einer vorteilhaften Weiterbildung des Ausführungsbeispiels wird das RS-Flip-Flop 9 durch ein Master-Slave-Flip-Flop ersetzt, das keine undefinierten Ausgangszustände Q, $\overline{Q}$ zuläßt, wie sie bei einem RS-Flip-Flop auftreten, wenn gleichzeitig S = R = 1 ist.

**Ansprüche**

1. Phasen- und frequenzempfindlicher Detektor für digitale Taktimpulse, insbesondere für eine Phasenregelschleife,
bestehend aus einer ersten Frequenzteilerschaltung (1) mit einem ersten zyklischen Zähler (5), einer zweiten Frequenzteilerschaltung (2) mit einem zweiten zyklischen Zähler (6) und einer bistabilen Kippschaltung (9) mit einem ersten Eingang (R) und einem zweiten Eingang (S) sowie einem ersten Ausgang (Q) und einem zweiten Ausgang ( $\overline{Q}$ ), wobei der ersten Frequenzteilerschaltung (1) Eingangstaktimpulse und der zweiten Frequenzteilerschaltung (2) Bezugstaktimpulse sowie dem ersten Eingang (R) Signale aus der ersten Frequenzteilerschaltung (1) und dem zweiten Eingang (S) Signale aus der zweiten Frequenzteilerschaltung (2) zugeführt werden,
**dadurch gekennzeichnet,**
daß die erste Frequenzteilerschaltung (1) eine erste Logikschaltung (7) und die zweite Frequenzteilerschaltung (2) eine zweite Logikschaltung (8) enthalten, wobei der ersten Logikschaltung (7) ein Signal aus dem ersten Ausgang (Q) der bistabilen Kippschaltung (9) und Signale aus dem ersten zyklischen Zähler (5) und der zweiten Logikschaltung (8) ein Signal aus dem zweiten Ausgang ( $\overline{Q}$ ) der bistabilen Kippschaltung (9) und Signale aus dem zweiten zyklischen Zähler (6) zugeführt werden, und daß die Logikschaltungen (7, 8) bei einem bestimmten Zustand der ihnen zugeführten Signale die zyklischen Zähler (5, 6) auf einen von ihrer normalen Zählfolge abweichenden Zählerstand schalten.

2. Phasen- und frequenzempfindlicher Detektor nach Anspruch 1,
dadurch gekennzeichnet,
daß die erste Logikschaltung (7) das Weiterzählen des ersten zyklischen Zählers (5) solange verhindert, bis auf einen Zustand am ersten Ausgang (Q) der bistabilen Kippschaltung (9) der zu diesem Zustand komplementäre gefolgt ist und daß die zweite Logikschaltung (8) das Weiterzählen des zweiten zyklischen Zählers (6) solange verhindert, bis auf einen Zustand am zweiten Ausgang ( $\overline{Q}$ ) der bistabilen Kippschaltung (9) der zu diesem Zustand komplementäre gefolgt ist.

3. Detektor nach einem der vorgehenden Ansprüche,
dadurch gekennzeichnet,
daß die bistabile Kippschaltung (9) ein Master-Slave-Flip-Flop ist.

FIG.1

FIG.2

FIG.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-A-3 520 301 (ANT NACHRICHTENTECHNIK) * Seite 4, Zeile 32 - Seite 7, Zeile 12; Figuren 1-5 * --- | 1-3 | H 03 D 13/00 G 01 R 25/00 |
| X,D | US-A-3 723 889 (OBERST) * Spalte 2, Zeile 53 - Spalte 4, Zeile 53; Figuren 1-3 * --- | 1-3 | |
| A | US-A-3 987 365 (OKADA et al.) * Spalte 3, Zeile 16 - Spalte 4, Zeile 16; Figuren 3,4 * ----- | 3 | |
| | | | **RECHERCHIERTE SACHGEBIETE (Int. Cl.5)** H 03 D G 01 R |

Der vorliegende Recherchenbericht wurde für alle Patentansprüche erstellt

| Recherchenort | Abschlußdatum der Recherche | Prüfer |
|---|---|---|
| DEN HAAG | 15-03-1990 | BALBINOT H. |

EPO FORM 1503 03.82 (P0403)